# EUROPEAN PATENT SPECIFICATION

(11) **EP 0 428 161 B1**
(45) Date of publication and mention of the grant of the patent: **17.02.1999**
(21) Application number: 90121808.1
(22) Date of filing: 14.11.1990
(51) Int. Cl.: H01J 37/34, H01J 37/32

(54) **Dry process system**
Trocken-Behandlungsvorrichtung
Dispositif de traitement sec

(30) Priority: 15.11.1989 JP 298694/89
(43) Date of publication of application: 22.05.1991
(73) Proprietor: KOKUSAI ELECTRIC CO., LTD., Tokyo-to (JP); Kinoshita, Haruhisa, Shizuoka-ken (JP)
(72) Inventor: Kinoshita, Haruhisa, Shizuoka-ken (JP); Matsumoto, Osamu, Akishima-shi, Tokyo (JP); Sakuma, Harunobu, Nishitama-gun, Tokyo (JP)
(74) Representative: Walter, Helmut, Dipl.-Ing.

(56) References cited:
- EP-A- 0 140 130
- EP-A- 0 172 916
- EP-A- 0 251 567
- GB-A- 1 522 059
- US-A- 3 325 394
- PATENT ABSTRACTS OF JAPAN vol. 8, no. 46 (C-212)(1483) 29 February 1984, & JP-A-58 204174 (HITACHI SEISAKUSHO K.K.) 28 November 1983

## Description

The present invention relates to a dry process system in which a magnetron discharge is used, the system comprising a chamber having an inlet for a reaction gas and an exhaust port for exhaust gas, more than three electrodes arranged at regular intervals and parallel with each other, wherein a magnetron discharge is generated between adjacent electrodes, respectively.

Apparatus of this type can be used for CVD systems, etching systems, and sputtering systems.

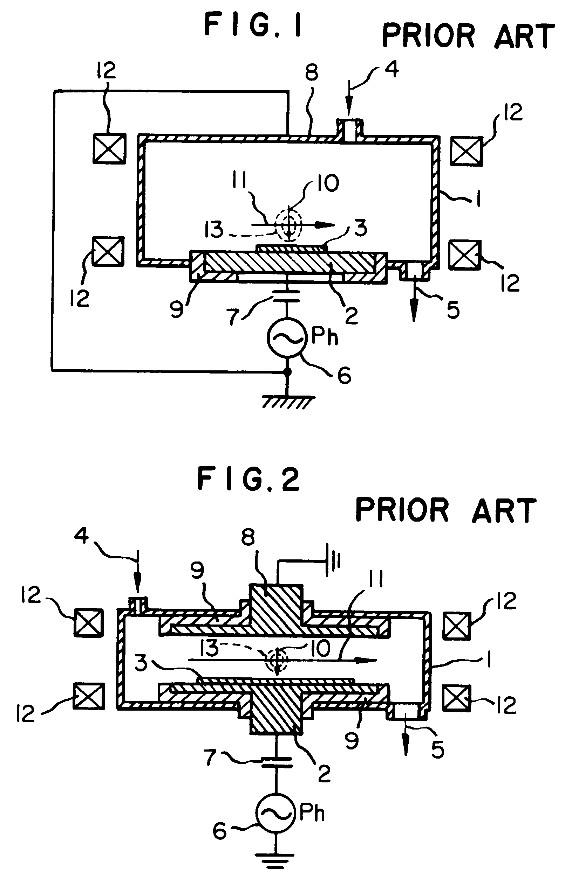

Fig 1 is a schematic illustration of an example of a conventional dry process system.

The conventional dry process system comprises a chamber 1, a cathode electrode 2 provided on the bottom of chamber 1 with said electrode being insulated from chamber 1 by an insulator 9 The cathode electrode 2 is connected through a blocking capacitor 7 with one terminal of a high frequency power source or RF power source 6, while the other terminal of the high frequency power source and the chamber 1 are grounded Three pairs or three sets of solenoids 12 are provided outside the chamber 1 for generating a magnetic field 11 in directions nearly parallel to the surface of the cathode electrode 2. Substrate or wafer 3 is disposed on the cathode electrode 2. Reaction gas 4 is introduced into chamber 1 while exhaust gas 5 is discharged from chamber 1. High frequency power Ph of 13.56 MHz is applied through the blocking capacitor 7 to the cathode electrode 2 Chamber 1 acts as an anode electrode 3. A high frequency electric field 10, which is perpendicular to a surface of the cathode electrode 2, is generated over the cathode electrode 2, while a magnetic field parallel to the surface of the cathode electrode 2 is generated by the solenoids.

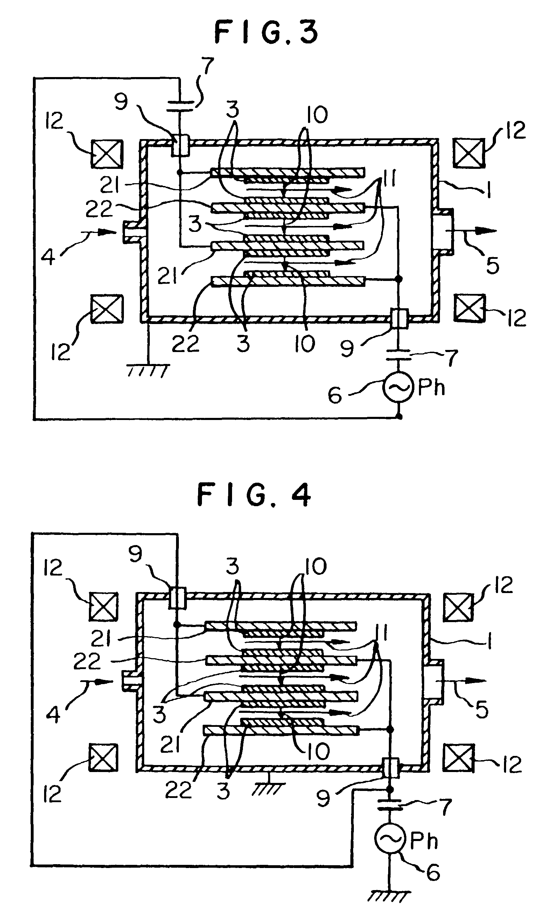

Fig. 2 is a schematic illustration of another example of a conventional dry etching system.

The conventional dry etching system has the same construction as the former conventional system except that an anode electrode 8 is opposed to a cathode electrode 2 at height of about 70 mm above the cathode electrode 2 in such a manner that the anode electrode 8 is parallel to the cathode electrode 2, and the anode electrode 8 is grounded.

These conventional systems operate a follows:
After substrate 3 to be etched has been disposed on the cathode electrode 2, chamber 1 is sufficiently evacuated by a vacuum pump, and the reaction gas 4 is introduced into chamber 1 at a gas pressure of about 1,3 Pa. Thereafter, high frequency power Ph from the high frequency power source is supplied to the cathode electrode 2 through the blocking capacitor 7, thereby exciting the reaction gas into plasma consisting of positive ions and negative electrons. As a result of the supply of high frequency power to the cathode electrode, a high frequency electric field 10 is generated, perpendicular to the surface of the cathode electrode 2.

Thereby, a magnetic field 11 is generated parallel to the surface of the cathode electrode 2 by means three pairs or three sets of solenoids. The high frequency electric field 10 and the magnetic field 11 intersecting each other in a space above the substrate cause spiral cycloidal motion of light electrons along an orbit of small radius and in a direction perpendicular to the magnetic lines of force, said electrons violently colliding with the neutral etching gas, as a result of which density plasma and thereby, magnetron discharge 13 is generated.

Since the electrons in the magnetic field are caused to drift by Lorenz forces in a direction perpendicular to the magnetic field, a one-sided distribution of plasma densities takes place. To prevent this, three pairs or three sets of solenoids are arranged around chamber 1, and alternating current is passed through the tree sets of solenoids, thereby generating a rotating magnetic field which apparently equalizes the distribution of plasma density.

Usually, the ionization rate of the reaction gas in the excitation of said gas due to high frequency electric discharge is small, about 10⁻⁴. However, since the ionization rate of the magnetron discharge exceeds the former ionization rate by two digits, 10⁻², the etching rate is increased by more than one digit as a result of the magnetron discharge.

However, in the above-mentioned system, uniform etching is difficult under the static magnetic field, because of the one-sided distribution of plasma densities. The etching accuracy varies greatly and has a fluctuation of more than ±30%. Furthermore, it is impossible to etch more than two substrates disposed on both the cathode electrode 2 and the anode electrode 8 at the same time, because the self-bias voltage of the cathode electrode 2 differs greatly from that of the anode electrode 8. Besides it has been considered as being still more impossible to provide more than three electrodes in a chamber, dispose substrates on the respective electrodes and etch the substrates at the same time and with good uniformity.

### SUMMARY OF THE INVENTION

Dry process systems provided with more than two electrodes are also known (GB-A-1 522 059 and EP-A-140 130). The system described in the first mentioned document does not apply magnetic fields. EP-A-140 130 describes a system with a plurality of electrode-pairs facing each other, wherein one pair is always a cathode electrode whereas the other pair is always an anode electrode, so that electrons are emitted only from one electrode-pair, namely the cathode electrodes. Accordingly, it is one object of the present invention to provide a dry process system wherein multiple electrodes are arranged at regular intervals in a chamber and a plurality of substrates disposed on the respective electrodes can be processed at the same time and with good uniformity.

The above-mentioned object can be achieved in accordance with the present invention by a dry process system as defined in claim 1. The more than three electrodes are connected to an alternating current power source through a blocking capacitor.

Instead of the blocking capacitor a power distributing unit can be used in accordance with claim 6.

Furthermore, the above-mentioned object of the present invention is also achieved by a dry process system as defined in claim 11 in which the electrodes are connected to the negativ side of a direct current power source instead of an alternating current one in which the chamber being connected to the positive side of said direct current power source and grounded.

In the present invention, the distance between adjacent electrodes is 1 to 5 cm, preferably 1 to 3 cm.

In the present invention, internal pressure of the chamber is about 1 to 100 mTorr, preferably 0,13 to 1,3 Pa. Furthermore, in the present invention, the magnetic field is about 0,5 x 10⁻² to 5 x 10⁻² Tesla.

In the present invention, it is preferable that the respective electrodes should have equal surface areas and equal distances between each other.

In the present invention, when an alternating current power source is used as a power source for the dry process system, the alternating current power source may be provided for supplying synchronously alternating current power with the same frequency to each electrode through the blocking capacitor under the appropriate phase difference.

Furthermore, the alternating current power source can be provided for supplying synchronously alternating current power with the same frequency to each electrode through the blocking capacitor nearly under the same phase, wherein the chamber is grounded. In this case, the first group of electrodes and the second group of electrodes may be electrically connected to each other.

In the present invention, a set of a first alternating current power source and a second alternating current power source can be used as an alternating current power source for the dry process system, wherein said first alternating current power source is connected to the second alternating current power source via a phase shifter.

In the present invention, the phase difference is in the region of 0°±40° or 180°±40°.

In the present invention, when gas for film forming such as SiH is used, the dry process system according to the present invention can be used as a CVD (chemical vapor deposition) system. When an etching gas such as CF is used, this system can be used as an etching system. Furthermore, when sputtering gas such as Ar is used, this system can be used as a sputtering system.

According to the present invention, a magnetron discharge is generated as a result of the electric field and the magnetic field intersecting each other. This magnetron discharge generates plasma. Some light electrons present in the plasma run into each electrode and are stored in the blocking capacitor, and thereby a negative selfbias direct current voltage is formed.

With the formation of a self-bias voltage, an ion sheath with a high concentration of positive ions is formed in the neighborhood of each electrode. However, the electric resistance of the ion sheath increases due to the very low mobility of the positive ions, which cruses a strong electric field to build up in a direction perpendicular to each electrode. The electric field corresponding to the self-bias voltage formed in the ion sheath of each electrode runs against each electrode. The lines of the electric field corresponding to the self-bias voltage formed in the ion sheath of the first electrode are opposite in direction to the lines of the electric field corresponding to the self-bias voltage formed in the ion sheath of the second electrode opposite of the first electrode. Because the magnetic fields are in the same direction and one electric field corresponding to the first electrodes and the other electric field corresponding to the second electrodes are in opposite directions to each other, the direction of Lorenz forces acting on the secondary electrons emitted from each electrode are now opposite of each other.

When the distance between the adjacent electrodes is set so that electrons can travel nearly without collision in the space between said adjacent electrodes, that is, at the mean free path of the electrons one plasma generated in the neighborhood of one electrode and the other plasma generated in the neighborhood of the other electrode can mingle with each other so that an almost uniform distribution of mingled plasma takes place. Accordingly, nearly uniform plasma can be formed without the need of rotating magnetic field.

Furthermore, if the distance between the adjacent electrodes is set be substantially equal to the diameter of the electrons' rotation, that is, twice the Larmor's radius with which the electrons rotate about the magnetic lines of force, an ion sheath forms on the surface of each electrode, and the electrons are repulsed by the strong electric field of the ion sheath when running into it, thereby being forced to take the opposite direction again. Accordingly, there is a high probability that the rotating electrons keep rotating without condiserably drifting right and left in the space until they collide with the gas molecules. When the reaction gas is presurized and the circumference of a circle of the electrons rotation is so that electrons can travel nearly without collision, the electrons freely rotate about one circuite of the rotation before colliding with the gas molecules. The gas pressure is inversely proportional to the mean free path of the electrons. Therefore, to make the electrons rotate by more than a circuite of rotation, it is necessary to limit the gas pressure below the value under which electrons can travel nearly without collision.

Namely, if the distance between the adjacent electrodes is equal to or less than the value at which electrons can travel nearly without collision, said electrons can keep without drifting nearly right and left in the space between the adjacent electrodes before colliding with the gas molecules in the space, so that the uniforme plasma is generated. Besides, because the drift of electrons to the right and to the left is low, plasma having good uniformity is generated.

Since the ionization rate of plasma caused by magnetron discharge exceeds that of plasma caused by the alternating current discharge by two digits, dry etching according to the present invention can be performed at an exceeding rate that of the conventional system by more than 1 digit.

### BRIEF DESCRIPTION OF THE DRAWINGS

In the drawings:
Fig. 1 is a schematic illustration of an example of a conventional dry etching system belonging to the category of dry process systems;
Fig. 2 is a schematic illustration of another example of a conventional dry etching system belonging to the category of dry process systems;
Fig. 3 is a schematic illustration of a first embodiment of a dry process system according to the present invention;
Fig. 4 is a schematic illustration of a second embodiment of a dry process system according to the present invention;
Fig. 5 is a schematic illustration of a third embodiment of a dry process system according to the present invention;
Fig. 6 is a schematic illustration of a fourth embodiment of a dry process system according to the present invention;
Fig. 7 is a schematic illustration of a fifth embodiment of a dy process system according to the present invention;
Fig. 8(a) is a schematic representation of a model of electron transport process in plasma generated between electrodes opposed at a wide distance;
Fig. 8(b) is a schematic representation of a model of electron transport process in magnetron plasma generated between electrodes opposed at a narrow distance;
Fig. 9 is a graphical representation of the emission spectrum of CHF magnetron plasma;
Fig. 10 is a graphical representation of the gas pressure dependence on Ha emission intensity;
Fig. 11 is a graphical representation of the self-bias voltages (V) in the system according to the present invention and a conventional system to etching rate (µm/min); and
Fig. 12 is a graphical representation of etch depth distribution on a 6-inch SiO wafer etched under a rotating magnetic field.

### DETAILED DESCRIPTION OF THE INVENTION

The present invention is now explained by an example with reference to the drawings.

Fig. 3 is a schematic illustration of a first embodiment of a dry process system according to the present invention, in which the same reference characters as in Figs. 1 and 2 showing conventional systems designate like or corresponding parts as parts of the conventional systems shown in Figs. 1 and 2.

The first embodiment of the present invention comprises two first electrodes 21 and two second electrodes 22 which are arranged alternately and parallel to each other in the chamber 1. The first electrodes 21 are connected to one terminal of an AC or high frequency or RF power source 6 through a blocking capacitor 7 and the second electrodes 22 are connected to the other terminal of the high frequency power source 6 through a blocking capacitor 7. With a view to equalizing states of plasma being generated between the adjacent electrodes 21, 22, it is preferable that the distances between the adjacent electrodes are identical and the areas of the respective electrodes almost equal to each other so that the capacitor of the blocking capacitor 7 for the first electrodes and the capacitor of the blocking capacitor 7 for the second electrodes are almost equal to each other. A wire connecting the first electrodes 21 to one terminal of the high frequency power source 6 through the blocking capacitor 7 and a wire connecting the second electrodes 22 to the other terminal of the high frequency power source 6 through the blocking capacitor 7 are insulated form the chamber 1 by insulator 9, 9, respectively. Three pairs or three sets of solenoids 12 are arranged outside the chamber 1 surrounding the first and the second electrodes 21, 22 so that the magnetic field lines 11 are parallel to the first and the second electrodes 21, 22.

In the first embodiment the chamber 1 is grounded with a view to stabilizing plasma discharge.

Furthermore, in the first embodiment, the dry process system is provided with one high frequency power source. However, a two-unit set of high frequency power sources may be used the frequencies of which are synchronized at a phase difference of 180°, that is with opposite phases to each other so that the high frequency power sources are controlled to yield the same power. When such a two-unit set of high frequency power sources is used, a similar operation and effect can be also obtained by supplying high frequency power to the respective electrodes 21, 22 from the respective high frequency power sources through the respective blocking capacitors 7, 7. In this case, it is possible to change the electric energy supplied to the first electrodes as well as the electric energy supplied to the second electrodes and also to change the phase difference between the power supplied to the first electrodes and second electrodes, respectively. Furthermore, it is possible to optimize the distribution of plasma generated between the two electrodes 21, 22 by suitably adjusting the ratio of electric energy supplied to the first electrodes to the electric energy which is supplied to the second electrodes as well as the phase difference between power supplied to the first and second electrodes, respectively.

Furthermore, the solenoid 12 for applying a magnetic field can be replaced by other means for applying a magnetic field, for example by combined rod-shaped permanent magnets. Any means for applying a magnetic field 11 parallel to substrates 3 on the electrodes 21, 22 above the substrates can be used. Even under static magnetic field conditions, a sufficient uniformity of the plasma density can be obtained. However, if the magnets are rotated, the plasma density is further leveled off so that its uniformity is improved.

The substrates 3 are disposed on the electrodes 21, 22, respectively. However, it is not always necessary to arrange substrates 3 on both electrodes 21 and 22; but it is necessary only to dispose of either the electrodes 21 or the electrodes 22. Since it is desirable that the first electrodes 21 and the second electrodes 22 are as symmetric to each other as possible, both electrodes should be parallel to each other, and the ratio of the areas of the first electrodes 21 and the second electrodes 22 should be approximated as far as possible to 1:1. In this case, the blocking capacitor 7 for the first electrodes 21 and the blocking capacitor 7 for the second electrodes 22 should have the same capacity if possible.

In the first embodiment, the substrates 3 are disposed on the first electrodes 21 and the second electrodes 22. The air in chamber 1 is sufficiently exhausted by means of a vacuum pump, and thereafter a certain amount of reaction gas 4 is introduced into the chamber 1 so that the internal pressure of the chamber 1 reaches a value of about 0,13 to 13 Pa or lower and is adjusted accordingly. Electric current is sent through the solenoid 12, a magnetic field 11 of about 0,5 x 10⁻² to 5 x 10⁻² Tesla thereby being applied to the space between the two electrodes 21, 22 over the substrates 3 so that the magnetic field lines 11 run nearly parallel to the electrode 21, 22. Power Ph from the high frequency power source 6 is supplied through the blocking capacitors 7, 7 to the first electrodes 21 and to the second electrodes 22 with opposite phases to each other. An electric field 10 is generated over the substrates 3 by the applied power Ph. As a result of the electric field 10 and the magnetic field 11 intersecting at right angles, a magnetron discharge takes place. Plasma is generated by the magnetron discharge, so that a portion of the light electrons in the plasma run into the first electrodes 21 and into the second electrodes 22 and are stored in the blocking capacitors 7 so that a self-bias voltage is generated.

Ion sheaths with a higher positive ion density are generated in the neighborhood of the first electrodes 21 and the second electrodes 22 as a result of the generation of the self-bias voltage of negative direct current. The electric field lines 10 corresponding to the self-bias voltage generated in the ion sheaths of the first electrodes 21 and the second electrodes 22 run in upward and downward direction, respectively. Because the magnetic field lines 11 take the same direction, and owing to the fact that the electric field lines 10 have opposite directions to each other, the directions of the Lorenz forces acting on the secondary electrons emitted from each electrode 21, 22 are apposite to each other. Namely, in the neighborhood of the first electrodes 21, plasma density is higher at a region corresponding to the rear side of the paper on which figures are drawn (namely opposite side thereof), however it is lower at a region corresponding to the front side of the paper on which figures are drawn (this side). On the other hand, in the neighborhood of the second electrodes 22, the plasma density is lower at a region corresponding to the rear side of the paper on which figures are drawn (namely opposite side thereof), however it is higher at a region corresponding to the front side of the paper on which figures are drawn (this side).

If the distance between the first electrodes 21 and the second electrodes 22 is short enough so that the electrons can travel nearly without collision, the plasma generated in the neighborhood of the first electrodes 21 as well as the plasma generated in the neighborhood of the second electrode 22 are mingled with each other without being separated from each other so that distribution of plasma density is nearly uniform. Accordingly, almost uniform plasma can be generated without any rotating magnetic fields. Of course, the uniformity of plasma will be further improved if magnetic field is rotated. The preferable distance between the two electrodes 21, 22 is about 1 cm to 5 cm.

The ionization rate of plasma caused by the magnetron discharge exceeds that of plasma caused by the usual high frequency discharge by two digits. Therefore, dry etching can be performed by the first embodiment system at a high rate of more than one digit as compared to the conventional system.

When a film-forming gas such as SiH is used, this system can be used as CVD (chemical vapor deposition) system. When etching gas such as CF is used, this system can be used as an etching system. Furthermore, when sputtering gas such as Ar is used, this system can be used as a sputtering system.

The system of the first embodiment permits six substrates 3 to be processed at the same time. Furthermore, it is possible to process more than 12 pieces of substrates 3 at the same time by using this dry process system and disposing more than 2 pieces of substrates 3 on each electrode 21, 22. Furthermore, the total number of the first electrodes 21 and the total number of the second electrodes 22 may be higher than 3 or 5, respectivly, wherin it is necessary that the first electrodes 21 and the second electrodes 22 be arranged alternately. As mentioned before, the first electrodes 21 and the second electrodes 22 are preferably parallel to each other. However, it is not necessary that the electrodes 21, 22 have flat shapes; they may be of a curved shape as well.

Fig. 4 is a schematic illustration of a second embodiment of a dry process system according to the present invention, in which the same reference characters as in Fig. 3 designate the same or corresponding parts as in the system shown in Fig. 3.

The second embodiment comprises two first electrodes 21 and two second electrodes 22 which are electrically connected to each other so that the first electrodes 21 and the second electrodes 22 become equipotential to each other, and high frequency electric power Ph is synchronously supplied with equiphase to the respective electrodes 21, 22 from the high frequency power source 6 through the blocking capacitor 7. The chamber 1 is grounded. The high frequency power source 6 can be replaced by a two-unit set of high frequency power sources which are synchronized with equiphase and controlled to have equal power, thereby the similar operation and effect as in using one high frequency power source being obtained. In this case, electric energy and phase differences of the power supplied to the first and second electrodes from a two-unit set of high frequency power sources through the blocking capacitor may differ from each other. Therefore the distribution of the plasma generated between the two electrodes 21, 22 can be optimized by suitably adjusting the electric energy ratio of the power supplied to the first electrodes to the electric energy of the power supplied to the second electrodes and phase difference between the power supplied to the first and second electrodes, respectively. Furthermore, if one terminal of the respective frequency power sources is grounded, the chamber should be grounded. The magnetic field 11 is applied parallel to the electrodes 21, 22 by means of solenoid 12 as in the first embodiment. To improve plasma uniformity and generate plasma of high density, it is preferable to have a narrow distance between the first electrode 21 and the second electrode 22, in the range of about 1 cm to 5 cm. Said distance enables the electrons to travel almost without collision in the space between the first electrode 21 and the second electrode 22. The first electrodes 21 and the second electrodes 22 can be also electrically connected with each other by way of a conductive wire or a conductive plate inside the chamber 1 so that the same effect is obtained as in the case where the first and second electrodes are electrically connected with each other outisde the chamber.

In the first embodiment, the high frequency power source 6 is used as power source. However, in the present embodiment, the high frequency power source 6 can be replaced by a direct current power source. If the direct current power source is used, the blocking capacitor 7 is not required. Negative voltage is directly applied to each electrode 21, 22, while positive voltage is directly applied to the chamber 1 or to the electrode arranged inside the chamber. A substrate 3 or plurality of substrates 3 can be disposed on both electrodes 21, 22 or either electrode 21 or 22.

In the second embodiment, when a film-forming gas such as SiH is used in the same manner as in the system of the first embodiment this system can be used as a CVD system. When etching gas such as CF is used, this system can be used as an etching system. Furthermore, when sputtering gas such as Ar is used, this system can be used as a sputtering system. Apart from this, the conditions for generating plasma are almost the same as the conditions described in the first embodiment.

In the second embodiment, more than 3 electrodes can be used in the same manner as in the first embodiment, wherein it is preferable that the respective electrodes 21, 22 are electrically connected with each other so as to make them equipotential, the areas of the respective electrodes are similar to each other, the respective distances between the adjacent electrodes are almost similar to each other, and that the respective electrodes are parallel to each other. In this case, more than 4 substrates can be disposed on the opposed surfaces of the adjacent electrodes.

In the first and second embodiments, the frequency power source is used as a power source for generating plasma. However, a low frequency power source may also be used as a power source for generating plasma.

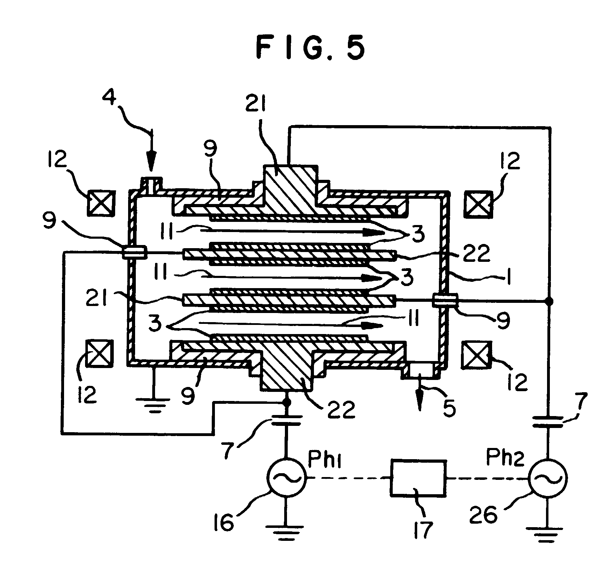

Fig. 5 is a schematic illustration of the third embodiment of a dry process system according to the present invention, in which the same reference characters as in Fig. 2 showing a conventional system designate the same parts as or parts corresponding to the parts of the conventional systems.

The third embodiment comprises two first electrodes 21 and two second electrodes 22 which are arranged alternately and parallel to each other in the chamber 1. In the third embodiment, as high frequency power sources for supplying independently high frequency electric powers Ph2, Ph1, the system is provided with high frequency power sources 26, 16. The first high frequency power source 16 and the second high frequency power source 26 are connected to each other through a phase shifter 17. A pair of high frequency power sources 26, 16 are controlled by means of a phase shifter 17 to oscillate at the same frequency at an optional phase difference. Independent control of the high frequency electric powers Ph1, Ph2 is possible. The first electrodes 21 are connected to one terminal of the second high frequency power source 26 while the second electrodes 22 are connected to one terminal of the first AC or high frequency power source 16. The other terminals of the respective high frequency power sources are grounded. To equalize conditions of plasma generated in each space between the adjacent electrodes, it is preferable that the respective distances between the adjacent electrodes are equal that the areas of the respective electrodes 21, 22 are almost equal, and that the capacities of the blocking capacitors 7, 7 for the first and the second electrodes are almost equal.

Furthermore, the solenoid 12 can be replaced by other means for applying magnetic field between the adjacent electrodes, for example by rod-shaped permanent magnetics which are combined into one. Any means for applying the magnetic field 11 nearly parallel to substrates 3 on the electrodes 21, 22 can be used. Even under a static magnetic field, enough uniformity of plasma density can be obtained. However if the magnetic field is rotated, the plasma density is further leveled off and its uniformity improved, thus.

In the third embodiment, the substrates 3 are disposed on the electrodes 21, 22, respectively. The chamber 1 is sufficiently evacuated, and thereafter a certain amount of reaction gas 4 is introduced into the chamber 1 so that the internal pressure of the chamber reaches 0,13 to 13 Pa or less. Electric current is sent through the solenoid 12, thereby generating a magnetic field 11 of about 0,5 x 10⁻² to 5 x 10⁻² Tesla in the space between the adjacent electrodes 21, 22 so that the magnetic field lines run nearly parallel to the electrodes 21, 22.

Electric power Ph1, Ph2 of the high frequency power sources 16, 26 is supplied to the respective electrodes 21, 22 through the blocking capacitor 7 at an arbitrary phase difference and an arbitrary power supply ratio and an electric field is generated above the substrates 3 by the application of power Ph1, Ph2. The direction of the electric field changes according to the phase difference and power supply ratio of power Ph1, Ph2. Magnetron discharge is generated as a result of the electric field 10 and the magnetic field 11 intersecting at right angles. Plasma is generated by the magnetron discharge, so that a portion of the light electrons in the plasma run into the first electrodes 21 and into the second electrodes 22, and are stored in the blocking capacitors 7 so that a negative self-bias voltage is generated. Ion sheaths with higher density are generated in the neighborhood of the first electrodes 21 and the second electrodes 22, thus causing a negative self-bias voltage. In the ion sheath section, there are positive ions having a high density. However, since the mobility of positive ions is remarkably low, the electric resistance of the ion sheath section increases so that strong electric field are applied in a direction perpendicular to the respective electrodes 21, 22. The directions of the electric fields corresponding to the self-bias voltage generated in the ion sheath sections of the first and second electrodes 21, 22 point toward the respective electrodes 21, 22, i.e. they turn upward and downward, respectively, in opposite direction to each other. The electric fields accelerate the positive ions which collide with the first and second electrodes 21, 22, thereby emitting secondary electrons.

Taking into account the above-mentioned conditions, the following differences between a wide and a narrow distance between adjacent electrodes occur: when the distance between the adjacent electrodes 21, 22 is changed, the following difference between a case where the distance between adjacent electrodes is wider and a case where the distance between both the electrodes is narrow.

This system permitts six substrates 3 to be processed at the same time. Furthermore, it is possible to process more than 12 pieces of substrates 3 at the same time by using this dry process system and disposing more than 2 pieces of substrates 3 on each electrode 21, 22. Furthermore, the total number of electrodes 21 and 22 may be higher than 3 or 5, respectively, wherein the first electrodes 21 and the second electrodes 22 should be arranged alternately. The first electrodes 21 and the second electrodes 22 are preferably parallel to each other. However, it is not necessary that the electrodes 21, 22 have flat shapes; they may be of a curved shape as well.

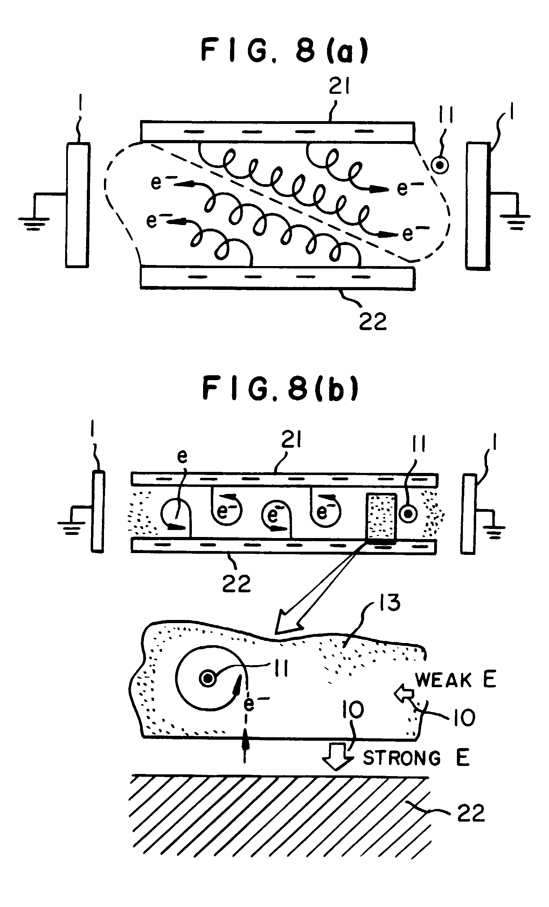

Fig. 8(a) shows the motions of electrons in plasma when the distance between the first and second electrodes 21, 22 is wider, for example about 60 mm to 100 mm. Because the distance between the adjacent electrodes is wide enough, secondary electrons emitted from the respective electrodes 21, 22 drift to the right and to the left. Due to the influence of the electric and the magnetic fields which intersect at right angles. Such a motion is referred to as cycloid motion. Because the secondary electrons emitted from the first electrode 21 drift to the right whereas the secondary electrons emitted from the second electrode 22 drift to the left.

Therefore, if the distance between the first and second electrodes 21, 22 is wider than the path in which the electrons can travel nearly without collision in the space between the electrodes 21, 22, the secondary electrons emitted from the first electrode 21 and the secondary electrons emitted from the second electrode 22 are separated from each other, and the plasma is separately produced in the neighborhood of the first electrodes 21 and in the neighborhood of the second electrodes 22. However if the distance between the first and second electrodes 21, 22 is substantially equal to the mean free path of the electrons, the electrons can travel nearly without collision in the space between the electrodes 21, 22, and the plasmas generated in the neighborhood of the electrodes mingle with each other so that distribution of the mingled plasma is homogenuos. The mean free path of the electrons is the average distance that the electrons can travel in the gas molecules until they collide with the gas molecules.

The effect magnetic field in the system will be described in connection with Fig. 8(b).

Fig 8(b) shows the motions of electrons in the plasma when the distance between the first and second electrodes 21, 22 is substantially equal to Larmor's diameter of the electrons. Namely, the distance is about 10 mm to 30 mm. Now, supposing that the magnetic flux density of the magnetic field and the self-bias voltage are 150 x 10⁻⁴ Tesla and 200 V, respectively, the radius of gyration of electron, that is Larmor's radius, is about 4 mm. Therefore, the diameter of rotation of the secondary electrons around the magnetic line of force is about 8 mm. There is a high probability that the secondary electrons rotating around the magnetic lines of force with a diameter of about 8 mm, approach the opposite electrodes. Because an ion sheath is formed on the surface of the electrodes, the electrons are repulsed by a strong negative electric field and returned in the opposite direction. Therefore, if the distance between the adjacent electrodes is narrow, the electrons are likely to continue rotating without largely drifting to the right and to the left until they collide with the gas molecules.

The circumference of a circle with a diameter of about 8 mm is about 25 mm The gas pressure under which the mean free path elongates to 25 mm is about 1,3 Pa (10 mTorr), although there are slight differences depending on various sorts of gas. Accordingly, in a gas with a pressure of 10 mTorr, electrons freely rotate about one circuite of the rotation under the above-mentioned plasma generation conditions, before they collide with the gas molecules. Since the length of the mean free path of the electrons is inversely proportional to the gas pressure, it is necessary to maintain the pressure under about 1,3 Pa (10 mTorr), so that the electrons can rotate more than one rotation. If the distance between the adjacent electrodes is about 10 to 30 mm, and the gas pressure below about 1,3 Pa (10 mTorr), the electrons continue rotating in the space between adjacent electrodes 21, 22 nearly without drifting to the right and to the left, and then collide with the gas molecules so that plasma consisting of ions or radicals is generated.

As the extent to which electrons drift to the right and to the left in Fig. 8(b) is small, electrons emitted from the respective electrodes 21, 22 continue to rotate about the magnetic lines of force in the space between the adjacent electrodes 21, 22, and effectively collide with the gas molecules so that plasma having better uniformity is generated. Consequently, as shown in Figs. 8(a) and (b), if the distance between the electrodes 21, 22 is substantially equal to or less than the mean free path of the electrons, the uniformity of the plasma between the electrodes 21, 22 is improved without rotating magnetic field, of course it is still more improved by a rotating magnetic field. In addition, the density of the plasma is also increased so that the efficiency in the etching process or the CVD process is improved.

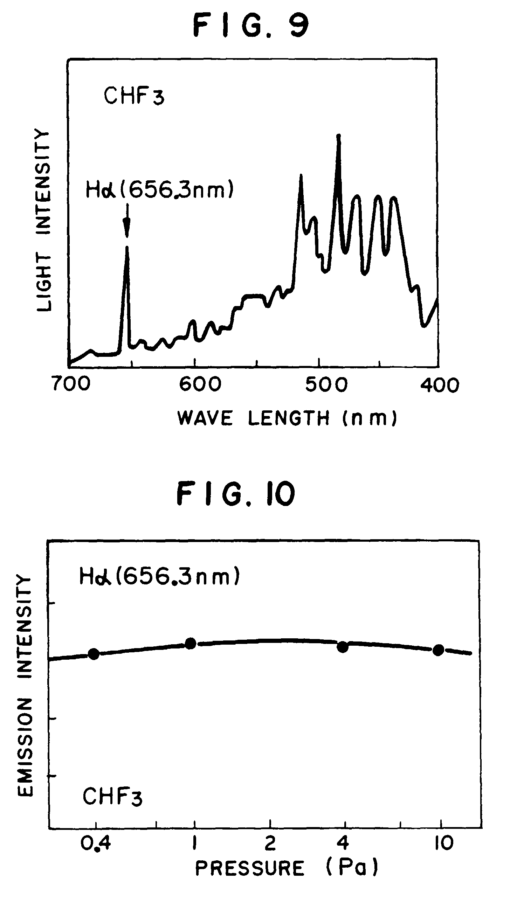

Fig. 9 shows the emission spectrum of CHF gas at a pressure of 1 Pa obtained by means of the system according to the third embodiment, wherein the bright-line spectrum of a wave length of 656.3 nm is an α-ray spectrum (Hα). The intensity of Hα-rays shows the light intensity of the hydrogen atoms generated by decomposition of CHF, and an extent of decomposition of CHF, that is plasma density. Fortunately, since there is only little noise light in the neighborhood of Hα-rays, the comparison of plasma densities can be achieved by the comparison of Hα-ray intensities.

Fig. 10 shows the gas pressure dependence of Hα-emission intensity when CHF gas is introduced into the system according to the third embodiment, and gas pressures thereof are changed from 0.4 to 10 Pa. As shown in Fig. 10, even if the gas pressure is lowered from 10 Pa to 0.4 Pa, the Hα-emission intensity remains almost the same. Although such lowering of the gas pressure from 10 Pa to 0.4 Pa corresponds to a weakening of the inside of the chamber by 40 times in terms of the gas molecule density, the density of the emitting plasma remains unchanged. In fact, the plasma generation efficiency is increased as the gas pressure is reduced to a value of less than about 1 Pa.

There are the following relations between the phase difference between power Ph2 and power Ph1 and plasma uniformities: at phase differences within the range of 0±40° from 0°, plasma uniformities are fairly good to the extent that plasma can be visually observed to be nearly uniform. In such plasma conditions and under the static magnetic field 11, a good etching uniformity of about ±15% can be obtained, whereas under said plasma conditions and under a rotating magnetic field 11, a fairly good etching uniformity of about ±3% can be obtained.

Then, if the phase differences are set within the range of about 180±40°, the plasma uniformity is somewhat reduced as compared to the plasma uniformities at phase differences in the range of about 180±40° to the extent that plasma having somewhat strong light emissions is visible at both ends of the space between the first and second electrodes 21, 22, which both ends are aligned with the directions perpendicular to the magnetic lines of force 11. The substrates 3 in the neighborhood of the plasma having strong light emission are etched at a somewhat higher etching rate as compared to the etching rate of the other region of the substrates, so the etching uniformity over whole area of the substrates is worse than at phase differences in the range of 0±40°. Under such conditions and under a static magnetic field 11, an etching uniformity of about ±30% can be obtained. Under the same plasma conditions and under a rotating magnetic field 11, a fairly good etching uniformity of about ±3% can be obtained. In the range of phase differences other than those mentioned above, an intermediate uniformity in the region between the uniformity obtained at phase differences in the neighborhood of 0° and the uniformity obtained at phase differences in the neighborhood of 180° can be obtained.

There is no very close relation between plasma density and phase difference. In any phase difference, a stronger plasma than the standard magnetron plasma is generated. Accordingly, in any phase the substrates can be etched at a higher rate than with the standard magnetron plasma. If an dielectric insulation plate is inserted between the first electrode 21 or the second electrode 22 and the substrate 3 disposed on the first electrode 21 or the second electrode 22, a phase difference between the high frequency power at the first electrode 21 or the second electrode 22 and the high frequency power at the substrates 3 is generated. In this case, it is preferable that the phase difference between the high frequency powers Ph 1 and Ph 2 is defined and considered as phase difference between the high frequency power Ph 1 applied to the substrate 3 and the high frequency power Ph 2 applied to the substrate 3.

Plasma uniformities are delicately influenced by the high frequency power supply ratio between the power Ph2 supplied to the first electrodes 21 and the power Ph1 supplied to the second electrodes 22. If the power supplied to either electrodes 21 or 22 or the power supplied to both the electrodes 21 and 22 is high enough, strong plasma is generated. In this case, if either the first or the second electrodes are grounded or if no power is supplied to either the first or the second electrodes, plasma with an extremely low degree of uniformity is generated and the plasma density is greatly reduced. For example, if the power Ph2 supplied to the first electrodes 21 is sufficiently high while the power Ph1 supplied to the second electrodes 22 is somewhat lower, a high density plasma is generated in the space between the first and second electrodes 21 and 22. The self-bias voltage at the first electrodes 21 increases, the ion sheath thickens and the kinetic energy of the positive ion incident on the substrate 3 increases. In contrast to this, the self-bias voltage of the second electrodes 22 is reduced, the ion sheath gets thinner and the kinetic energy of the positive ion incident on the substrate 3 is reduced. Therefore, such a system is suitable for etching the substrates 3 or sputtering at a high rate with high ion energy, while the second electrodes 22 can be used for etching or plasma processing and as CVD with a small amount of ion energy, at a fairly high rate and with little loss of ions by collision.

After equalizing the power Ph2 supplied to the first electrodes 21 and the power Ph1 supplied to the second electrodes 22, the system can be used for performing etching or plasma processing such as CVD the substrates 3 on the first and second electrodes 21 and 22 or plasma processing such as CVD under almost the same conditions. Therefore, if the ratio between the power supplied to either of the first electrodes 21 or the second electrodes 22 and the total power supplied to the first and second electrodes 21 and 22 is about 20 to 80%, strong higher density plasma can be generated in contrast to the standard magnetron plasma.

If the distance between the adjacent electrodes 21 and 22 is sufficiently narrow so that the electrons can move in the space between the first and second electrodes 21 and 22 and rotate around the magnetic lines of force almost without collision, the electrons emitted from the first and second electrodes 21 and 22 can continue rotating, thereby being moderately mixed in the space between the first and second electrodes 21 and 22. Therefore, plasma having a higher density than the standard magnetron plasma is generated with almost perfect uniformity. Accordingly, almost uniform plasma can be obtained under a static magnetic field. Of course, if the magnetic field is rotated, the plasma uniformity is further improved.

The ionization rate of plasma generated by magnetron discharge exceeds that of the ionization rate of plasma generated by the standard high frequency discharge. Therefore, dry etching can be performed by the third embodiment system at a rate exceeding that of the conventional system by one digit.

If a film-forming gas such as SiH is used, this system can be used as CVD system. When etching gas such as CF is used, this system can be used as an etching system. Furthermore, when sputtering gas such as Ar is used, this system can be used as a sputtering system.

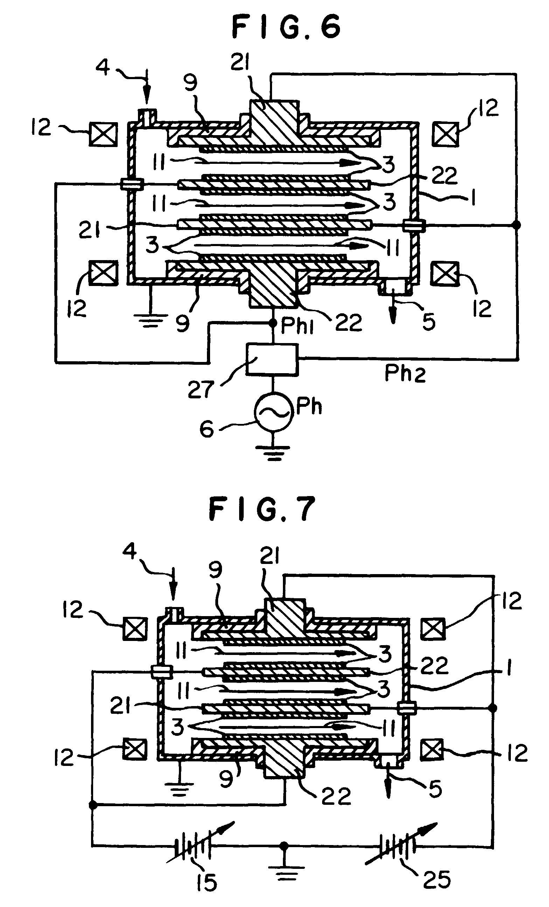

Fig. 6 is a schematic illustration of a fourth embodiment of a dry process system according to the present invention, in which the same reference characters as shown in Fig. 5 designate the same parts or corresponding parts as shown in Fig. 5.

The fourth embodiment comprises two first electrodes 21 and two second electrodes which are arranged alternately and parallel to each other in the chamber 1, which is grounded. The first and second electrodes are through a power distributor 27 with the high frequency power source 6. The other terminal of the high frequency power source 6 is grounded. To equalize the conditions for plasma generation in the spaces between the adjacent electrodes, it is preferable that the respective distances between the adjacent electrodes are identical and the areas of the respective electrodes 21, 22 are almost equal to each other, and that the blocking capacitors incorporated in the output units of the power distributor for the first and the second electrodes are also identical.

The power distributor 27 has a transformer for distribution of power of the one-input-to-two-output type, a phase control unit including a coil and a variable condenser, and a matching box for matching the impedance of the first electrode to the impedance of the second electrode. The matching box incorporates a blocking capacitor at the output units thereof. There are some combinations in respect of the number of the transformers for distribution of power, the phase control units and the matching box, a method for connecting them and the order of connection. However, it is considered that any units which can optionally control the ratio between power and phase difference for one input are coordinate with the above-mentioned power distributor. In the output distributor, it is not always necessary to have the transformer for distribution of power, the phase control unit and the matching box at a time. A similar effect can be obtained for example by simply branching an output from a matching box into two outputs. In this case, control of distribution rate and phase difference and optimization of the conditions of plasma generation are not easy, but this system is suitable for low cost systems which are relatively simple and composed of only a few parts.

The power distributor 27 branches high frequency power Ph of the high frequency power source 6 into first and second powers Ph1 and Ph2 having an optional ratio between power and phase difference, respectively, which can be supplied to the second electrode 22 and the first electrode 21. In such a manner, the same effect is achieved by one high frequency power source 6 as with two high frequency power sources 16 and 26.

Operation, operating procedure and operating state are almost the same as the dry process system in Fig. 5.

In the third and the fourth embodiments, the high frequency power source is used as a power source for generating plasma. However, the high frequency power source can be replaced by a low frequency power source.

Fig. 7 is an illustration of a fifth embodiment of the present invention, in which the same reference characters as in Fig. 5 designate the same or corresponding parts as in the system shown in Fig. 5.

The fifth embodiment comprises two first electrodes 21 and two second electrodes 22 which are arranged alternately and parallel to each other in the chamber 1. The first electrodes 21 are connected to the negative terminal of the second DC power source 25 whereas the second electrodes 22 are connected to the negative terminal of the first DC power source 15. The positive terminals of the DC power source 15, 25 are connected to the chamber 1 or are grounded. If the DC power sources are grounded, the chamber 1 is also grounded. To optionally control the power supplied to the first electrodes 21 and the power supplied to the second electrodes 22, the output voltages of the DC power sources 25, 15 should be optionally controllable. To optionally control the power supplied to the first electrodes 21 and the power supplied to the second electrodes 22, in the fifth embodiment, two DC power sources are used. However, the same action of the system is possible by dividing the output of one DC power source into two by means of a potential divider to supply power to the first and second electrodes 21, 22.

To equalize conditions of plasma generated in each space between the adjacent electrodes, it is preferable that the respective distances between the adjacent electrodes 21, 22 as well as the area of the electrodes 21, 22 are almost equal to each other.

In the fifth embodiment, if a film-forming gas such as SiH is used, the system can be used as a CVD system. If an etching gas such as CF is used, the system can be used as an etching system. Furthermore, if sputtering gas such as Ar is used, the system can be used as a sputtering system. Apart from this, the conditions for plasma generation are almost the same as shown in the third and fourth embodiments.

Furthermore, in the third through the fifth embodiments, it is preferable that the gas pressure is less than about 1 Pa and the distance between the first and second electrodes 21, 22 is about 10 mm to 30 mm. However, if the gas pressure is reduced and the mean free path is elongated, the distance between the first and second electrodes 21, 22 may be wider. It is advisable that the gas pressure is considered as being inversely proportional to the distance between the electrodes to determine the gas pressure and the distance between the adjacent electrodes. Since the distance between the first and second electrodes 21, 22 is substantially equal to the diameter of rotation of the electrons, and if the distance between adjacent electrodes is reduced, the diameter of rotation of the electrons should be smaller by increasing the magnetic field. Whereas if the distance between the electrodes is increased, the diameter of rotation of the electrons increases and the magnetic field intensity is decreased. The magnetic field intensity is considered as being generally inversely proportional to the diameter of rotation of the electrons. Accordingly, it implies that the magnetic field intensity is also inversely proportional to the distance between the first and second electrodes and proportional to the gas pressure. It is preferable that a magnetic field of about 150 to 200 Gauss be applied, if gas pressure is about 1 Pa and the distance between the adjacent electrodes is about 10 to 30 mm.

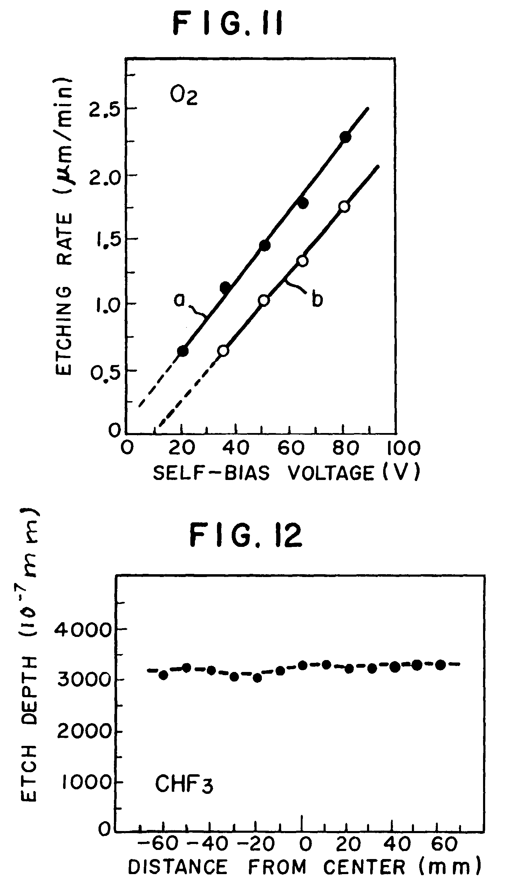

Fig. 11 is a graphical representation of the self-bias voltage dependence of the etching rate when photo resist is eched by 0 plasma.

In Fig. 11, line a shows the etching rates of photo resist by means of the dry process systems of the third through the fifth embodiments according to the present invention depending on self-bias vortage, and line b shows the etching rate of photo resist achieved by the conventional magnetron etching system. At a self-bias voltage of 35 V, the etching rate of photo resist by means of the third through the fifth embodiments is twice as high as that of photo resist by a conventional magnetron etching system. At a self-bias voltage over 35 V, the etching rate of photo resist by means of the third through fifth embodiments is also about fourty percent higher than the etching rate of photo resist achieved by a conventional magnetron etching system. This difference in etching rates implies a difference in plasma densities. It means that the dry process etching system of the third through the fifth embodiments according to the invention can produce plasma with a higher density than that produced by the conventional magnetron etching system.

The dry process systems of the third through the fifth embodiments can produce high density plasma with a fairly good uniformity, because the secondary electrons emitted from each electrode 21, 22 are rotated in the space between the first and second electrodes by the magnetic field 11 and shut off within said space. These plasma uniformities are by far superior to the standard magnetron plasma. This plasma uniformity can be further improved by the rotating magnetic field 11 so that the magnetic field intensities are equalized. The plasma uniformity can be determined by etching the substrates 3. Under a static magntic field, when etching is carried out by the standard magnetron plasma, there are variations in the etching rate of ±35%, therefore the substrates are not processed to close tolerance. On the contrary, when etching is carried out under a static magnetic field by means of the dry process systems of the third through fifth embodiments according to the present invention, the variations in the etching rate are ±15%, therefore the substrates can be processed to fairly close tolerance. Under a rotary magnetic field, the plasma uniformity is further improved to such an extent that an excellent etching uniformity of ±3% can be obtained used by using the dry process systems of the third through the ninth embodiments according to the present invention.

Fig. 12 is a graphical representation of etch depth distributions of 6 inch SiO substrate etched by introducing CHF gas into the dry process systems of the third through the fifth embodiments of the present inventions, wherein the etching time is about one minute and the magnetic field is rotating. Since the magnetic field rotates, variations in etching accuracy are distributed almost symmetrically in respect of the central axis of the substrates. The etching uniformity is about ±4%. Thus, the dry process system of the third through the fifth embodiment according to the present invention can produce more uniform magnetron plasma than a conventional dry process system.

Since the gas pressure at which magnetron discharge is obtained is fairly low, i.e. less than 1 Pa (7,5 mTorr), very directional etching is possible, and it is also possible to produce a thin film of high quality with only a small amount of impurities. Furthermore, since plasmas having almost the same conditions can be obtained in the neighborhood of the first and the second electrodes 21, 22, more than two substrates 3 disposed on the respective electrodes 21, 22 can be processed at the same time.

Furthermore, since the magnetic field is applied almost parallel to the substrates 3, it is hard for the electrons in the plasma to flow towards the substrates, so the formation of an ion sheath is difficult. Therefore, since the self-bias voltage is reduced to less than 1/5 of that in a conventional dry process system the damage caused by ions crushing on the substrates is decreased. For this reason, the dry process systems of the third through fifth embodiments according to the present invention are suitable especially for etching with a low rate of damage, vapor deposition of material for gate, trench etching or lead. Furthermore, according to the present invention, miniaturization of dry process system becomes possible.

## Claims

1. A dry process system in which a magnetron discharge is used, the system comprising a chamber (1) having an inlet for a reaction gas and an exhaust port for exhaust gas, more than three electrodes (21, 22) arranged parallel with each other and being connected through a blocking capacitor (7), respectively, to an alternating current power source (6) and comprising at least one magnetic field applying means (12) for generating a magnetic field (11) nearly parallel to the surface of each electrode (21, 22), whereby generating a magnetron discharge between adjacent electrodes, wherein all the adjacent electrodes are cathodes and wherein the distance between adjacent electrodes is set to be substantially equal to the mean free path of the electrons in the chamber at processing conditions.

2. A dry process system as claimed in claim 1, wherein said alternating current power source (6) supplies synchronously alternating current power having the same frequency to each electrode (21,22) through the blocking capacitor (7) under the appropriate phase difference.

3. A dry process system as claimed in claim 1, wherein a first group of electrodes (21) and a second group of electrodes (22) are electrically connected with each other.

4. A dry process system as claimed in claim 1, wherein said alternating current power source (6) supplies synchronously alternating current power having the same frequency to each electrode (21,22) through the blocking capacitor (7) nearly under the same phase, and the chamber (1) is grounded.

5. A dry process system as claimed in claim 1, wherein said alternating current power source comprises a set of a first alternating current power source (26) and a second alternating current power source (16), said dry process system further comprises a phase shifter (17) inserted between the first alternating current power source and the second alternating current power source, a first group of electrodes (21) are connected with the first alternating current power source (26) through the first blocking capacitor (7) and a second group of electrodes (22) are connected with the second alternating current power source (16) through the second blocking capacitor (7).

6. A dry process system as claimed in claim 1, wherein said electrodes (21,22) are connected to the power source (6) through a power distributing unit (27)respectively instead of the blocking capacitor (7).

7. A dry process system as claimed in claim 6, wherein said alternating current power source (6) is provided for supplying synchronously alternating current power with the same frequency to each electrode through the power distribution unit (27) under the appropriate phase difference.

8. A dry process system as claimed in claim 6, wherein said alternating current power source (6) is provided for supplying synchronously alternating current power with the same frequency to each electrode (21,22) through the power distribution unit (27) nearly under the same phase, and wherein the chamber (1) is grounded.

9. A dry process system as claimed in claim 2 or 7, wherein said phase difference is within a range of 0° ± 40°.

10. A dry process system as claimed in claim 2 or 7, wherein said phase difference is within a range of 180° ± 40°.

11. A dry process system in which a magnetron discharge is used, the system comprising a chamber (1) having an inlet for a reaction gas and an exhaust port for exhaust gas and being connected to the positive side of a direct current power source (25) and grounded, comprising more than three electrodes (21,22) arranged parallel with each other and being connected to the negative side of the direct current power source, respectively, and comprising at least one magnetic field applying means (12) for generating a magnetic field (11) nearly parallel to the surface of each electrode (21, 22), whereby generating a magnetron discharge between adjacent electrodes, wherein all the adjacent electrodes are cathodes and wherein the distance between adjacent electrodes is set to be substantially equal to the mean free path of the electrons in the chamber at processing conditions.

12. A dry process system as claimed in claim 1, 6 or 11, wherein the distance between adjacent electrodes (21,22) is 1 to 5 cm, the chamber (1) is evacuated to a pressure of about 0,13 to 13 Pa or thereunder and wherein a magnetic field of about 0,5x10⁻² to 5x10⁻² Tesla is generated.

13. A dry process system as claimed in claim 1, 6 or 11, wherein the distance between adjacent electrodes (21,22) is 10 to 30 mm, the pressure inside the chamber (1) is below about 1,3 Pa and wherein a magnetic field of about 1,5x10⁻² to 2,0x10⁻² Tesla is generated.

14. A dry process system as claimed in claim 1, 6 or 11, wherein the respective electrodes (21,22) have areas equal to each other, respectively, and the respective distances between adjacent electrodes are equal to each other.

## Patentansprüche

1. Trockenbehandlungsvorrichtung unter Verwendung einer Magnetronentladung mit einer Kammer (1) mit einem Einlaß für die Reaktionsgas, einer Auslaßöffnung für ein Auslaßgas und mehr als drei Elektroden (21, 22) in paralleler Anordnung zueinander und in jeweiliger Verbindung mit einer Wechselstromquelle (6) über einen Blockkondensator (7), wobei mittels mindestens einem Mittel (12) zur Erzeugung eines magnetischen Feldes (11) nahezu parallel zu der Fläche jeder Elektrode (21, 22) elektrische Felder erzeugt werden, wobei eine Magnetronentladung zwischen einander benachbarten Elektroden bewirkt wird, wobei alle benachbarten Elektroden Kathoden sind und wobei der Abstand zwischen benachbarten Elektroden so bestimmt ist, daß er im wesentlichen dem mittelfreien Pfad der Elektronen in der Kammer unter Prozeßbedingungen entspricht.

2. Trockenbehandlungsvorrichtung wie in Anspruch 1 beansprucht, wobei die Wechselstromquelle (6) an jede Elektrode (21,22) mittels des Blockkondensators (7) synchron alternierend einen Leistungsstrom angepaßter Phasendifferenz liefert.

3. Trockenbehandlungsvorrichtung wie in Anspruch 1 beansprucht, wobei eine erste Gruppe Elektroden (21) und eine zweite Gruppe von Elektroden (22) miteinander elektrisch verbunden sind.

4. Trockenbehandlungsvorrichtung wie in Anspruch 1 beansprucht, wobei die Wechselstromquelle (6) an jede Elektrode (21, 22) mittels des Blockkondensators (7) synchron alternierend einen Leistungsstrom gleicher Frequenz und nahezu gleicher Phase liefert und die Kammer (1) geerdet ist.

5. Trockenbehandlungsvorrichtung wie in Anspruch 1 beansprucht, wobei die Wechselstromquelle einen Satz aus einer ersten Wechselstromquelle (26) und aus einer zweiten Wechselstromquelle (16) aufweist, wobei die Trockenbehandlungsvorrichtung einen zwischen erster und zweiter Wechselstromquelle eingeschalteten Phasenschieber (17) einschließt und wobei die Elektroden einer ersten Gruppe von Elektroden (21) durch den ersten Blockkondensator (7) mit der ersten Wechselstromquelle (16) verbunden sind und die Elektroden einer zweiten Gruppe von Elektroden (22) durch den zweiten Blockkondensator (7) mit der zweiten Wechselstromquelle (16) verbunden sind.

6. Trockenbehandlungsvorrichtung wie in Anspruch 1 beansprucht, wobei jede der Elektroden (21, 22) mit der Stromquelle (6) durch eine Stromverteilereinheit (27) statt durch den Blockkondensator (7) verbunden ist.

7. Trockenbehandlungsvorrichtung wie in Anspruch 6 beansprucht, wobei die Wechselstromquelle (6) vorgesehen ist, um an jede Elektrode mittels der Stromverteilereinheit (27) synchron alternierend einen Leistungsstrom angepaßter Phasendifferenz zu liefern.

8. Trockenbehandlungsvorrichtung wie in Anspruch 6 beansprucht, wobei die Wechselstromquelle (6) an jede Elektrode (21, 22) mittels der Leistungsverteilereinheit (27) synchron alternierend einen Leistungsstrom gleicher Frequenz und nahezu gleicher Phase liefert und die Kammer (1) geerdet ist.

9. Trockenbehandlungsvorrichtung wie in Anspruch 2 oder Anspruch 7 beansprucht, wobei die Phasendifferenz im Bereich von 0° ± 40° liegt.

10. Trockenbehandlungsvorrichtung wie in Anspruch 2 oder Anspruch 7 beansprucht, wobei die Phasendifferenz im Bereich von 180° ± 40° liegt.

11. Trockenbehandlungsvorrichtung unter Verwendung einer Magnetronentladung mit einer geerdeten Kammer (1) mit einem Einlaß für ein Reaktionsgas, einer Auslaßöffnung für ein Auslaßgas in Verbindung mit der positiven Seite einer Gleichstromquelle (25) und mit mehr als drei Elektroden (21, 22) in paralleler Anordnung zueinander und in jeweiliger Verbindung mit der negativen Seite der Gleichstromquelle, wobei mittels mindestens einem Mittel (12) zur Erzeugung eines magnetischen Feldes (11) nahezu parallel zu der Fläche jeder Elektrode (21, 22) elektrische Felder erzeugt werden, wobei eine Magnetronentladung zwischen einander benachbarten Elektroden bewirkt wird, wobei alle benachbarten Elektroden Kathoden sind und wobei der Abstand zwischen benachbarten Elektroden so bestimmt ist, daß er im wesentlichen dem mittel freien Pfad der Elektronen in der Kammer unter Prozeßbedingungen entspricht.

12. Trockenbehandlungsvorrichtung wie in einem der Ansprüche 1, 6 und 11 beansprucht, wobei der Abstand zwischen benachbarten Elektroden (21, 22) 1 bis 5 mm beträgt, die Kammer auf einen Druck von etwa 0,13 bis 13 Pa evakuiert ist und ein Magnetfeld von etwa 0,5 x 10⁻² bis 5 x 10⁻² Tesla aufgebaut wird.

13. Trockenbehandlungsvorrichung wie in einem der Ansprüche 1, 6 und 11 beansprucht, wobei der Abstand zwischen benachbarten Elektroden (21, 22) 10 bis 30 mm beträgt, der Druck in der Kammer (1) unter etwa 1,3 Pa liegt und ein Magnetfeld von etwa 1,5 x 10⁻² bis 2,0 x 10⁻² Tesla aufgebaut wird.

14. Trockenbehandlungsvorrichtung wie in einem der Ansprüche 1, 6 und 11 beansprucht, wobei jede der Elektroden (21, 22) die gleiche Fläche wie die gleichflächengroßen anderen Elektroden hat und die Abstände zwischen je zwei benachbarten Elektroden gleich sind.

## Revendications

1. Système de traitement à sec dans lequel une décharge de magnétron est utilisée, le système comprenant une chambre (1) comportant un orifice d'entrée destiné à un gaz de réaction et un orifice d'évacuation destiné à l'évacuation du gaz, plus de trois électrodes (21, 22) agencées parallèlement les unes aux autres et qui sont reliées par l'intermédiaire d'un condensateur d'arrêt (7), respectivement, à une source d'alimentation en courant alternatif (6) et comprenant au moins un moyen d'application de champ magnétique (12) destiné à générer un champ magnétique (11) presque parallèlement à la surface de chaque électrode (21, 22), en générant ainsi une décharge de magnétron entre des électrodes adjacentes, dans lequel toutes les électrodes adjacentes sont des cathodes et dans lequel la distance entre des électrodes adjacentes est réglée pour être pratiquement égale au trajet libre moyen des électrons dans la chambre pour les conditions de traitement.

2. Système de traitement à sec selon la revendication 1, dans lequel ladite source d'alimentation en courant alternatif (6) applique une alimentation en courant alternatif de façon synchrone présentant la même fréquence, à chaque électrode (21, 22) par l'intermédiaire du condensateur d'arrêt (7) sous la différence de phase appropriée.

3. Système de traitement à sec selon la revendication 1, dans lequel un premier groupe d'électrodes (21) et un second groupe d'électrodes (22) sont reliées électriquement les unes aux autres.

4. Système de traitement à sec selon la revendication 1, dans lequel ladite source d'alimentation en courant alternatif (6) applique de façon synchrone une alimentation en courant alternatif présentant la même fréquence à chaque électrode (21, 22) par l'intermédiaire du condensateur d'arrêt (7) presque avec la même phase, et la chambre (1) est mise à la masse.

5. Système de traitement à sec selon la revendication 1, dans lequel ladite source d'alimentation en courant alternatif comprend un ensemble d'une première source d'alimentation en courant alternatif (26) et d'une seconde source d'alimentation en courant alternatif (16), ledit système de traitement à sec comprend en outre un déphaseur (7) inséré entre la première source d'alimentation en courant alternatif et la seconde source d'alimentation en courant alternatif, un premier groupe d'électrodes (21) est relié à la première source d'alimentation en courant alternatif (26) par l'intermédiaire du premier condensateur d'arrêt (17) et un second groupe d'électrodes (22) est relié à la seconde source d'alimentation en courant alternatif (16) par l'intermédiaire du second condensateur d'arrêt (7).

6. Système de traitement à sec selon la revendication 1, dans lequel lesdites électrodes (21, 22) sont reliées à la source d'alimentation (6) par l'intermédiaire d'une unité de distribution d'alimentation (27), respectivement, à la place du condensateur d'arrêt (7).

7. Système de traitement à sec selon la revendication 6, dans lequel ladite source d'alimentation en courant alternatif (6) est prévue pour appliquer une alimentation en courant alternatif de façon synchrone avec la même fréquence à chaque électrode par l'intermédiaire de l'unité de distribution d'alimentation (27) sous la différence de phase appropriée.

8. Système de traitement à sec selon la revendication 6, dans lequel ladite source d'alimentation en courant alternatif (6) est prévue pour appliquer une alimentation en courant alternatif de façon synchrone à la même fréquence à chaque électrode (21, 22) par l'intermédiaire de l'unité de distribution d'alimentation (27) presque avec la même phase, et dans lequel la chambre (1) est mise à la masse.

9. Système de traitement à sec selon la revendication 2 ou 7, dans lequel ladite différence de phase est à l'intérieur d'une plage de 0° ± 40°.

10. Système de traitement à sec selon la revendication 2 ou 7, dans lequel ladite différence de phase est à l'intérieur d'une plage de 180°± 40°.

11. Système de traitement à sec dans lequel une décharge de magnétron est utilisée, le système comprenant une chambre (1) comportant un orifice d'entrée destiné à un gaz de réaction et un orifice d'évacuation destiné à l'évacuation d'un gaz et qui est relié au côté positif d'une source d'alimentation en courant continu (25) et mis à la masse, comprenant plus de trois électrodes (21, 22) agencées parallèlement les unes aux autres et qui sont reliées au côté négatif de la source d'alimentation en courant continu, respectivement, et comprenant au moins un moyen d'application de champ magnétique (12) destiné à générer un champ magnétique (11) presque parallèlement à la surface de chaque électrode (21, 22), en générant ainsi une décharge de magnétron entre des électrodes adjacentes, dans lequel toutes les électrodes adjacentes sont des cathodes et dans lequel la distance entre des électrodes adjacentes est réglée pour être pratiquement égale au trajet libre moyen des électrons dans la chambre pour les conditions de traitement.

12. Système de traitement à sec selon la revendication 1, 6 ou 11, dans lequel la distance entre des électrodes adjacentes (21, 22) est de 1 à 5 cm, la chambre (1) est vidée jusqu'à une pression d'environ 0,13 à 13 Pa ou moins, et dans lequel un champ magnétique d'environ 0,5 x 10 ⁻² à 5 x 10⁻² Tesla est généré.

13. Système de traitement à sec selon la revendication 1, 6 ou 11, dans lequel la distance entre des électrodes adjacentes (21, 22) est de 10 à 30 mm, la pression à l'intérieur de la chambre (1) est en dessous d'environ 1,3 Pa et dans lequel un champ magnétique d'environ 1,5 x 10 ⁻² à 2,0 x 10⁻² Tesla est généré.

14. Système de traitement à sec selon la revendication 1, 6 ou 11, dans lequel les électrodes respectives (21, 22) présentent des surfaces égales les unes aux autres, respectivement, et les distances respectives entre des électrodes adjacentes sont égales les unes aux autres.
